(19) Europäisches Patentamt European Patent Office Office européen des brevets

(11) **EP 1 501 161 B1**

(12) **FASCICULE DE BREVET EUROPEEN**

(45) Date de publication et mention
de la délivrance du brevet:
**14.02.2007 Bulletin 2007/07**

(51) Int Cl.:
**H01S 5/183** (2006.01)    **H01S 5/026** (2006.01)

(21) Numéro de dépôt: **04103435.6**

(22) Date de dépôt: **19.07.2004**

(54) **Diode à cavité résonante, fonctionnant à la même longueur d'onde pour l'émission et la détection de lumière**

Resonanzhohlraum-Diode, die bei der gleichen Wellenlänge für Lichtemission und Lichtdetektion betrieben wird

Resonant cavity diode, operating at the same wavelength for emission and detection of light

(84) Etats contractants désignés:
**AT BE BG CH CY CZ DE DK EE ES FI FR GB GR HU IE IT LI LU MC NL PL PT RO SE SI SK TR**

(30) Priorité: **23.07.2003 FR 0350362**

(43) Date de publication de la demande:
**26.01.2005 Bulletin 2005/04**

(73) Titulaire: **COMMISSARIAT A L'ENERGIE ATOMIQUE**
**75015 Paris (FR)**

(72) Inventeur: **Grosse, Philippe**
**38360, Sassenage (FR)**

(74) Mandataire: **Poulin, Gérard et al**
**Brevatome**
**3, rue du Docteur Lancereaux**
**75008 Paris (FR)**

(56) Documents cités:
**EP-A- 1 041 690**         **WO-A-01/26102**
**US-A- 4 202 000**        **US-A- 4 948 960**
**US-A- 5 533 041**        **US-A- 5 978 401**

- **STRITE S ET AL: "Tunable photodetectors and light-emitting diodes for wavelength division multiplexing" ELECTRONICS LETTERS, IEE STEVENAGE, GB, vol. 31, no. 8, 13 avril 1995 (1995-04-13), pages 672-674, XP006002710 ISSN: 0013-5194**
- **ZAKHAROV S M ET AL: "OPTOELECTRONIC INTEGRATED CIRCUITS UTILISING VERTICAL-CAVITY SURFACE-EMITTING SEMICONDUCTOR LASERS" QUANTUM ELECTRONICS, AMERICAN INSTITUTE OF PHYSICS, WOODBURY, NY, US, vol. 29, no. 9, septembre 1999 (1999-09), pages 745-761, XP000923961 ISSN: 1063-7818**

**Description**

## DOMAINE TECHNIQUE

La présente invention concerne une diode à cavité résonante et, plus précisément, une structure particulière de diode laser à cavité verticale, appelée VCSEL, qui peut être utilisée aussi bien comme émetteur que comme récepteur/ (détecteur) de lumière.

Rappelons qu'un VCSEL est un laser à émission par la surface, à cavité verticale (« vertical cavity surface emitting laser »). On utilisera l'acronyme VCSEL dans toute la suite de la présente description.

La structure particulière, objet de l'invention, ne présente pas les limitations classiques des dispositifs connus, auxquels on cherche à donner la double fonction d'émetteur-récepteur et sur lesquels on reviendra par la suite.

Les applications du composant objet de l'invention sont essentiellement :

- la télémétrie classique ou tridimensionnelle et

- les liens ou liaisons optiques pour les données ou les télécommunications mais également les liaisons entre cartes électroniques ou à l'intérieur d'un circuit électronique.

Revenons sur l'application à la télémétrie classique ou tridimensionnelle.

Un VCSEL émet une impulsion lumineuse qui est réfléchie par un objet et revient vers ce VCSEL. L'impulsion lumineuse est alors retransformée en impulsion électrique. Connaissant le temps écoulé entre les deux impulsions, on peut calculer la distance de l'objet.

Si l'on utilise une matrice de composants (VCSELs), l'impulsion de départ est émise par un seul des composants de la matrice mais l'impulsion réfléchie est reçue par tous les composants de cette matrice. Les décalages temporels, qui sont différents selon le point considéré de la matrice, permettent de connaître la distance et la forme de l'objet. En outre, un balayage point par point de la matrice permet de voir l'objet sous plusieurs angles.

Revenons maintenant à l'application aux liaisons optiques pour les données ou les télécommunications et aux liaisons entre cartes électroniques ou à l'intérieur d'un circuit électronique.

Le gain de place et de poids, qui est obtenu grâce à la structure objet de l'invention, peut apporter des avantages dans le domaine aéronautique et le domaine spatial. Enfin, la reconfiguration d'un réseau est facilement envisageable avec ce type de composant.

Si l'on applique l'invention à une LED ou diode électroluminescente (« light emitting diode ») placée dans une cavité résonante pour constituer ce que l'on appelle une RCLED, on obtient une diode mixte, qui est à la fois émettrice et réceptrice.

Rappelons qu'une RCLED est une diode électroluminescente à cavité résonante (« resonant cavity light emitting diode »). Il s'agit d'une structure quasiment identique à la structure d'un VCSEL. La différence essentielle entre ces structures réside dans la réflectivité des miroirs, qui est beaucoup plus faible pour la RCLED. Dans cette dernière, on ne cherche pas à obtenir l'effet laser mais seulement à rendre la diode plus lumineuse.

On peut alors utiliser le composant, qui résulte de l'application de l'invention à une RCLED, en tant que composant d'extrémité avec des fibres optiques plastiques, dans des liaisons à faible coût, pour l'industrie automobile par exemple.

La structure d'une LED placée dans une cavité résonante est quasiment identique à celle d'un VCSEL, comme on l'a vu plus haut. Ainsi, le principe décrit en ce qui concerne les VCSEL est directement applicable aux RCLEDs.

## ETAT DE LA TECHNIQUE ANTERIEURE

Faisons d'abord un rappel technique concernant les VCSELs utilisés en tant qu'émetteurs de lumière, c'est-à-dire de manière classique, avant de passer aux VCSELs utilisés en tant que détecteurs de lumière.

Comme tout laser, un VCSEL comporte deux miroirs qui délimitent une cavité résonante, et un milieu à gain qui est placé dans cette cavité et généralement formé de puits quantiques (« quantum wells »). Tout ces éléments résultent de l'empilement de couches semi-conductrices appropriées sur un substrat semi-conducteur.

Dans une diode laser classique, comme par exemple un laser ruban (« stripe laser »), les miroirs sont obtenus par clivage de la structure qui est déposée sur le substrat.

La différence d'indice optique entre l'air (dont l'indice est égal à 1) et le matériau semi-conducteur de la structure (dont l'indice vaut environ 3 ou 4) crée une interface qui réfléchit la lumière. On obtient de cette manière une réflectivité d'environ 30%, ce qui est relativement faible.

Par contre, comme la cavité obtenue mesure quelques centaines de micromètres, l'interaction entre les photons et le milieu à gain est facilitée et le gain est élevé.

Dans le cas des VCSELs, les miroirs sont obtenus en alternant des couches quart d'onde de semiconducteurs ayant respectivement un indice optique élevé et un indice optique faible.

Remarquons que la grande majorité des VCSELs actuellement commercialisés est réalisée en utilisant la famille des alliages binaires GaAs et AlAs ainsi que l'alliage ternaire $Ga_{1-x}Al_xAs$ qui est une solution solide des deux alliages binaires précédents.

Or, l'indice optique de GaAs (respectivement AlAs) vaut approximativement 3,5 (respectivement 2,9) dans le domaine proche infrarouge. En faisant varier la teneur x en aluminium dans l'alliage ternaire $Ga_{1-x}Al_xAs$, on peut donc faire varier l'indice optique dans l'intervalle allant de 2,9 à 3,5.

Revenons aux miroirs des VCSELS. En empilant un nombre suffisant de couches, on obtient un miroir de réflectivité élevée -typiquement 99,9 % - à la longueur d'onde d'émission du VCSEL comportant ce miroir. Cette réflectivité élevée permet de compenser le faible gain de la partie amplificatrice du VCSEL. En effet, contrairement au cas du laser ruban, la lumière traverse cette partie perpendiculairement et la longueur d'interaction est très faible.

On peut donc résumer la situation de la façon suivante :

1 .Un laser ruban a un gain fort, une cavité longue et des miroirs de faible réflectivité.

2. Un VCSEL a un gain faible, une cavité courte et des miroirs de forte réflectivité.

La figure 1 illustre schématiquement la structure d'un laser ruban classique. On voit la cavité 2 de ce laser, qui est comprise entre deux faces clivées constituant des miroirs 4 et 6.

La figure 2 illustre schématiquement la structure d'un VCSEL classique, comprenant un premier miroir de Bragg 8, qui est déposé sur un substrat 10, une cavité 12, qui est en GaAlAs dans l'exemple et contient un milieu à gain constitué par un ou plusieurs puits quantiques, et un second miroir de Bragg 16.

Le miroir 8 (respectivement 16) est un empilement où alternent des couches 8a (respectivement 16a) d'un matériau semiconducteur de faible indice optique et des couches 8b (respectivement 16b) d'un matériau semiconducteur de fort indice optique.

La cavité 12, délimitée par les deux miroirs, a une longueur optique qui est généralement égal à $k x \lambda$, $\lambda$ étant la longueur d'onde de fonctionnement du VCSEL et k étant un nombre entier supérieur ou égal à 1. C'est pourquoi cette cavité est appelée « cavité $k$ x $\lambda$ ».

Rappelons que la longueur optique de la cavité est la longueur obtenue en multipliant la longueur réelle de cette cavité par l'indice optique du matériau à partir duquel on constitue la cavité. Par exemple, avec du GaAs dont l'indice vaut environ 3,5, pour fabriquer une cavité qui résonne à une longueur d'onde de 850nm, on peut déposer 850/3,5=242,86nm de GaAs, en choisissant k égal à 1. L'épaisseur réelle de la couche de GaAs vaut alors 242,86nm et sa longueur optique est égale à 850nm.

En général, le substrat 10 et le premier miroir 8 sont faits de matériaux semiconducteurs de type N. La cavité 12 est non dopée et le second miroir 16, ou miroir supérieur, est fait de matériaux semiconducteurs de type P.

On forme des contacts électriques ohmiques 18 et 20 en déposant un métal sur la face arrière du substrat 10 et sur le miroir supérieur 16. En général, ce métal est un alliage d'or et d'un dopant de type N ou P (par exemple Ge ou Zn) et l'on ajoute à cet alliage des métaux (par exemple Ti, Pt, Ni) qui font office de barrières de diffusion ou qui améliorent l'adhérence.

Le contact supérieur 20 est annulaire pour permettre le passage du faisceau laser F qui est engendré par le VCSEL.

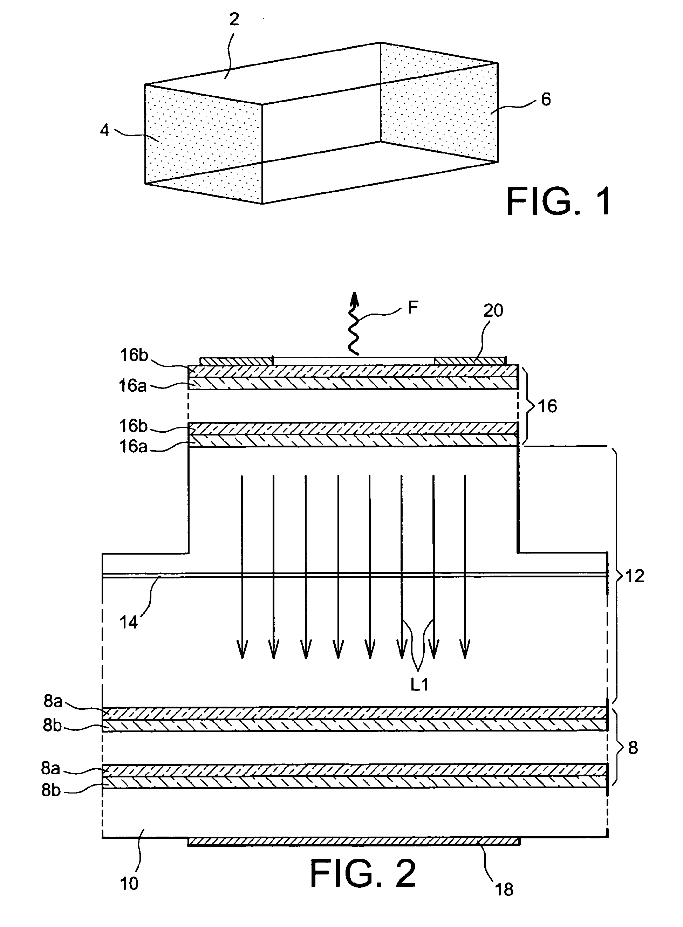

Dans la structure représentée sur la figure 2, les lignes de courant L1, qui sont obtenues lorsqu'on applique une tension entre les électrodes 18 et 20, ne sont pas guidées.

On a également cherché à diminuer le seuil de courant du VCSEL de la figure 2. La solution la plus élégante que l'on ait trouvée est la technique de l'oxydation latérale. Elle consiste à inclure dans la cavité, au moins d'un côté des puits quantiques, une couche de GaAlAs à forte teneur en aluminium. Cette couche est en général placée entre les puits et le miroir supérieur.

Après l'épitaxie permettant de former l'empilement des miroirs et de la cavité résonante, on grave l'échantillon résultant pour dégager les flancs de la cavité et l'on place le tout dans une atmosphère oxydante, généralement dans un four que l'on porte à environ 400 °C et dans lequel on fait pénétrer de la vapeur d'eau.

La couche de GaAlAs à forte teneur en aluminium se transforme alors en oxyde d'aluminium AlOx qui est un isolant électrique. Si l'on connaît la vitesse d'oxydation du GaAlAs, on peut arrêter le processus avant que la couche soit totalement oxydée et l'on obtient un anneau électriquement isolant.

Cette technique permet de concentrer les lignes de courant et d'augmenter la densité de courant, ce qui a pour effet de diminuer le seuil de fonctionnement du VCSEL.

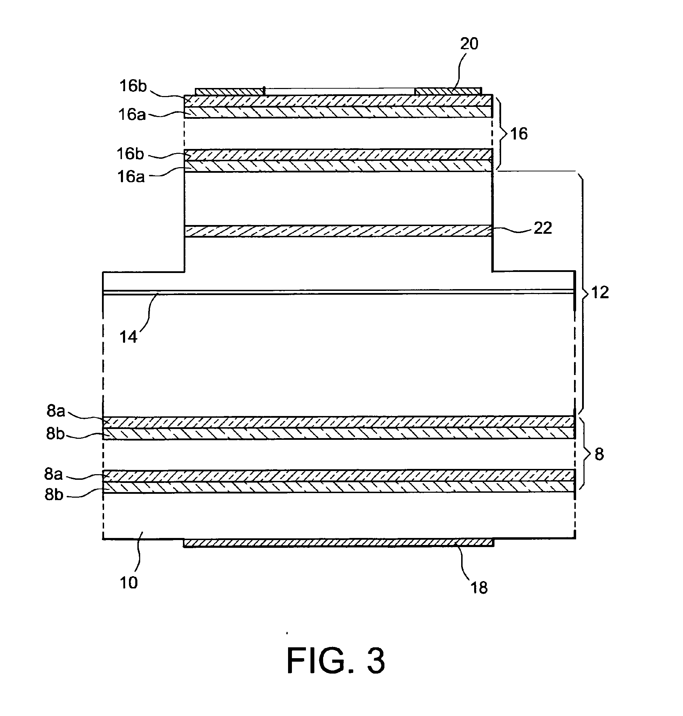

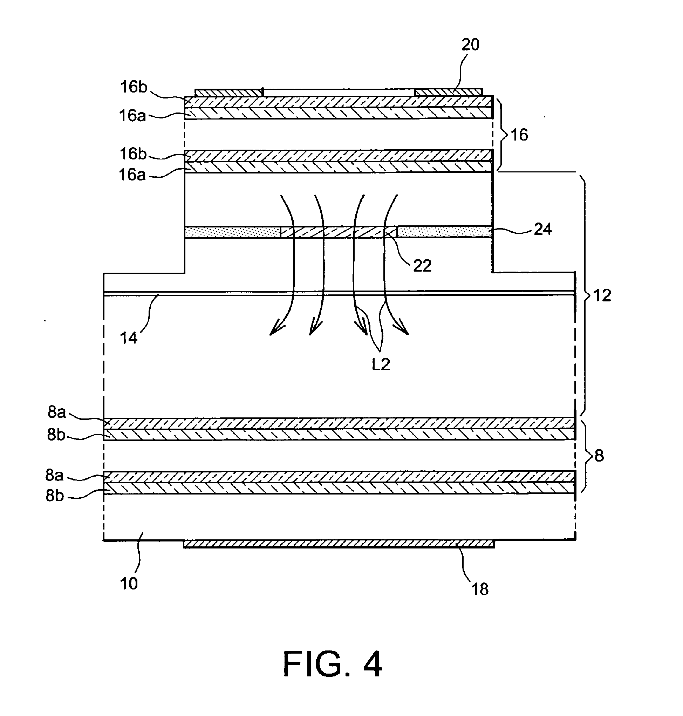

Les figures 3 et 4 sont des vues schématiques de la structure du VCSEL, respectivement avant et après l'oxydation latérale. Sur les figures 2, 3 et 4, les mêmes éléments ont les mêmes références.

La couche de GaAlAs à forte teneur en aluminium a la référence 22 sur la figure 3 et l'anneau électriquement isolant, en AlOx, a la référence 24 sur la figure 4. Les lignes de courant concentrées sont représentées sur la figure 4 et ont la référence L2.

Pour un VCSEL, les diamètres obtenus sont généralement dans les intervalles suivants : 5 à 10 $\mu$m pour la fenêtre centrale non oxydée ( la zone qui laisse passer le courant) et quelques dizaines de micromètres pour le diamètre total de l'anneau isolant.

Faisons maintenant quelques rappels sur les VCSELs utilisés en tant que détecteurs ou fonctionnant de manière mixte (en tant qu'émetteurs et détecteurs).

On sait que l'on peut également utiliser un VCSEL en tant que détecteur de lumière (voir le document [1] qui, comme les autres documents cités par la suite, est mentionné à la fin de la présente description).

La structure du VCSEL est, en effet, complètement réversible et il suffit de l'éclairer avec une source centrée sur la longueur d'onde d'émission de ce VCSEL pour faire de ce dernier un photo-détecteur très sélectif car seule la lumière centrée sur le pic de résonance de la cavité qu'il comporte pourra y pénétrer.

On peut même jouer sur la réflectivité de l'un des miroirs (références 8 et 16 sur les figures 2 à 4) pour ajuster la sélectivité du photo-détecteur (voir le document [2]). Si l'on enlève des bicouches de l'un de ces miroirs, on élargit la fenêtre de détection (une bicouche étant un couple de couches (8a et 8b par exemple) adjacentes).

Par contre, si l'on enlève des bicouches d'un miroir, l'effet laser ne peut plus avoir lieu dans le VCSEL. On se place en effet dans une situation très défavorable car le gain est faible et la réflectivité du miroir aussi. Il s'agit là du premier inconvénient important de cette technique : on ne peut pas obtenir un laser mixte. Il faut réserver cette solution aux seules LED placées dans des cavités résonantes. Cependant nous allons voir qu'il existe un autre inconvénient plus gênant.

Si l'on laisse le miroir supérieur intact, il faut distinguer deux cas : le cas du VCSEL de première génération (figure 2) et le cas du VCSEL avec oxydation latérale (figure 4). Dans le premier cas, on obtient un composant mixte mais ce dernier présente l'inconvénient d'avoir un seuil de fonctionnement élevé lorsqu'il est utilisé en tant qu'émetteur.

Dans le deuxième cas, un autre problème se pose : le chemin optique dans la cavité n'est pas le même selon que l'on traverse, ou non, la couche oxydée (l'indice optique de cette dernière valant environ 1,6), de sorte que le VCSEL détecte à deux longueurs d'ondes différentes, correspondant aux deux épaisseurs optiques de la cavité (voir les documents [3] et [4]).

De plus, si l'on veut augmenter l'efficacité du mode détecteur, on a intérêt à augmenter un peu le diamètre du VCSEL. La partie en regard de l'oxyde AlOx devient alors plus importante et le détecteur répond préférentiellement à une longueur d'onde plus courte que celle de la partie laser.

En conséquence, ce VCSEL ne sera pas capable de détecter la lumière provenant d'un autre VCSEL émettant à la même longueur d'onde que lui. Il faudra donc associer au premier VCSEL un deuxième VCSEL émettant à une longueur d'onde plus courte. Ce deuxième composant ne pourra pas non plus détecter la lumière provenant du premier car il détectera à une lumière de longueur d'onde encore plus courte etc..., d'où un cercle vicieux.

De même, si un VCSEL est utilisé pour éclairer un objet, ce VCSEL ne pourra pas être utilisé pour détecter la lumière renvoyée par cet objet.

On ne peut donc pas former une liaison bidirectionnelle avec des VCSELs mixtes. Il s'agit là du deuxième inconvénient important.

## EXPOSÉ DE L'INVENTION

La présente invention a pour but de remédier aux inconvénients précédents. Elle vise en particulier à résoudre le problème qui suit.

Si l'on fabrique un VCSEL que l'on veut utiliser aussi bien comme émetteur que comme détecteur, on obtient soit un émetteur qui n'est pas optimisé, soit un dispositif qui ne détecte pas correctement à la même longueur d'onde que la partie émettrice.

De façon précise, la présente invention a pour objet une diode à cavité résonante, apte à émettre et à détecter une lumière de longueur d'onde $\lambda$, cette diode comprenant :

- des premier et deuxième miroirs,
- une cavité résonante délimitée par ces premier et deuxième miroirs,
- un milieu actif contenu dans cette cavité et apte à émettre et à détecter la lumière,
- un premier anneau électriquement isolant qui est parallèle aux premier et deuxième miroirs et placé dans la cavité d'un côté du milieu actif, ce premier anneau définissant deux parties dans la cavité, à savoir une première partie cylindrique qui traverse le premier anneau et une deuxième partie qui contient ce premier anneau,

cette diode étant caractérisée en ce qu'elle comprend en outre au moins un deuxième anneau électriquement isolant qui est parallèle aux premier et deuxième miroirs et placé dans la cavité d'un côté du milieu actif, ce deuxième anneau étant contenu dans la deuxième partie de la cavité et ayant le même diamètre intérieur et le même diamètre extérieur que le premier anneau, l'épaisseur totale des premier et deuxième anneaux étant prévue pour que la cavité résonante ait une longueur optique kxλ dans la première partie et une longueur optique (k-1)xλ dans la deuxième partie, k étant un nombre entier au moins égal à 2.

Selon un mode de réalisation préféré de la diode objet de l'invention, les premier et deuxième anneaux sont formés par oxydation partielle de couches semiconductrices qui sont parallèles aux premier et deuxième miroirs et comprises dans la cavité, l'oxydation ayant lieu dans toute la portion de ces couches qui est située dans la deuxième partie de la cavité et k étant supérieur à n1/(n1-n2), où n1 et n2 désignent respectivement l'indice optique du matériau constitutif des couches semiconductrices et l'indice optique de ce matériau après oxydation.

Selon un mode de réalisation particulier de la diode objet de l'invention, la cavité est faite d'un matériau semiconducteur ternaire $A_{1-x}B_xC$, apte à être oxydé, avec $0 \leq x \leq 1$.

Les éléments chimiques A, B et C peuvent être respectivement Ga, Al et As.

Selon un premier mode de réalisation particulier de l'invention, le milieu actif est un milieu à gain et la diode est un laser à émission par la surface, à cavité verticale.

Selon un deuxième mode de réalisation particulier de l'invention, le milieu actif est apte à émettre et à détecter la lumière et la diode est une diode électroluminescente à cavité résonante.

La présente invention concerne aussi un télémètre comprenant la diode conforme à l'invention qui constitue un laser à émission par la surface, à cavité verticale.

L'invention concerne en outre un composant émetteur-récepteur de lumière, comprenant une matrice de diodes conformes à l'invention.

L'invention concerne également un télémètre à trois dimensions, comprenant une matrice de diodes conformes à l'invention, chacune de ces diodes constituant un laser à émission par la surface, à cavité verticale.

De plus, l'invention concerne une liaison optique bidirectionnelle comprenant :

- deux diodes émettrices-réceptrices conformes à l'invention, et
- un guide d'onde optique qui relie ces deux diodes.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés, sur lesquels :

- la figure 1 est une vue en perspective schématique de la structure d'un laser ruban classique et a déjà été décrite,
- la figure 2 est une vue en coupe schématique de la structure d'un VCSEL connu et a déjà été décrite,
- la figure 3 est une vue en coupe schématique d'un autre VCSEL connu, dont la cavité contient une couche destinée à être oxydée et a déjà été décrite,
- la figure 4 est une vue en coupe schématique de cet autre VCSEL après l'oxydation de cette couche et a déjà été décrite,

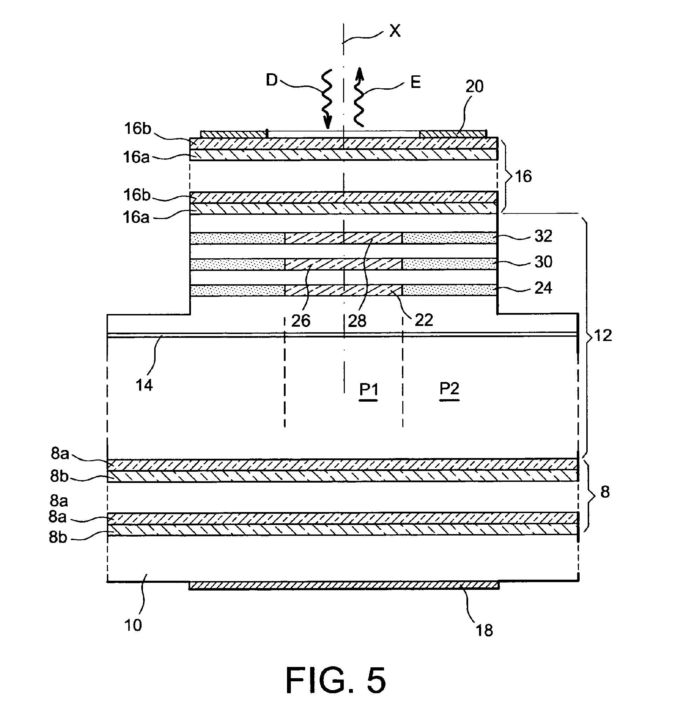

- la figure 5 est une vue en coupe schématique d'un VCSEL conforme à l'invention,

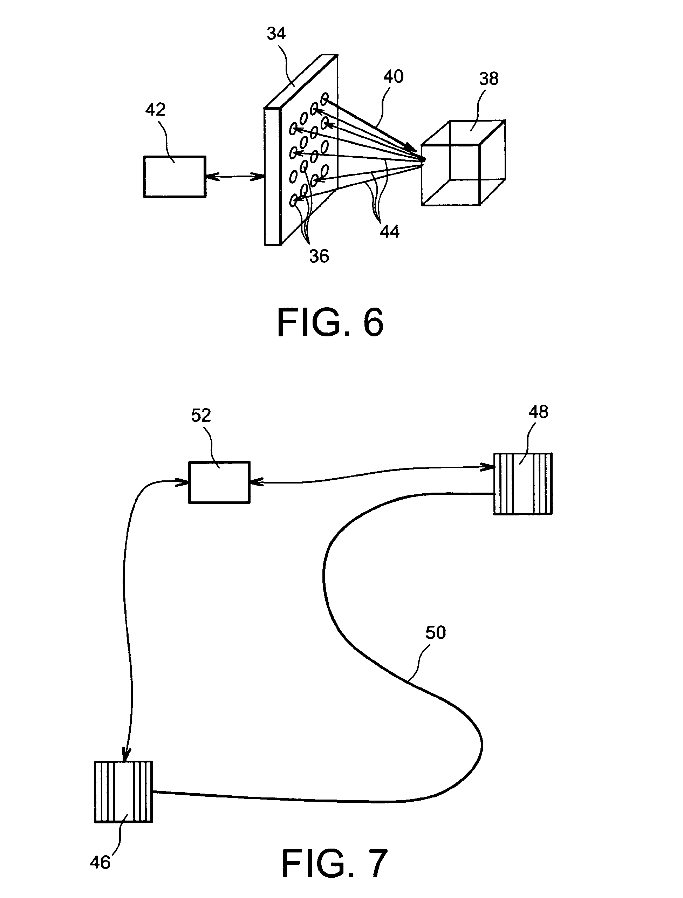

- la figure 6 illustre schématiquement l'application de la présente invention à la télémétrie tridimensionnelle, et
- la figure 7 illustre schématiquement l'application de la présente invention à la formation d'une liaison optique bidirectionnelle.

## EXPOSÉ DÉTAILLÉ DE MODES DE RÉALISATION PARTICULIERS

Conformément à l'invention, la solution du problème posé plus haut consiste, pour un VCSEL du genre de la figure 4, à ajouter une ou plusieurs couches oxydables à celle qui existe déjà (couche 24). Ces couches sont redondantes pour la fonction de guidage des lignes de courant mais permettent de transformer localement la cavité *k*xλ, en cavité (*k*-1)xλ.

Pour passer d'une cavité *k*xλ à une cavité (*k*-1)xλ, on exploite le fait que l'indice optique de AlAs passe de 2,9 à environ 1,6 quand il est oxydé en AlOx (en considérant le cas particulier où la couche 22 de la figure 3 est en $Ga_{1-y}Al_yAs$, avec y=1). L'épaisseur réelle de AlAs ne varie quasiment pas mais son épaisseur optique est fortement diminuée.

Il suffit d'utiliser une épaisseur totale de AlAs suffisante pour que le changement de longueur optique soit exactement égal à λ. Les épaisseurs doivent donc satisfaire les équations suivantes, dans lesquelles on a considéré le cas particulier où la cavité est en $Ga_{1-x}Al_xAs$, avec x=0.

$$N(AlAs)xD(AlAs)+N(GaAs)xD(GaAs)=kx\lambda \qquad (1)$$

$$N(AlOx)xD(AlAs)+N(GaAs)xD(GaAs)=(k-1)x\lambda \qquad (2)$$

Dans ces équations, N(AlAs), (N(AlOx) et N(GaAs) désignent respectivement l'indice optique de AlAs, l'indice optique de AlOx et l'indice optique de GaAs et D(AlAs) et D(GaAs) désignent respectivement l'épaisseur totale de AlAs et l'épaisseur totale de GaAs.

L'équation (1) décrit la longueur optique de la cavité avant l'oxydation et l'équation (2) décrit la longueur optique de la même cavité après cette oxydation. En retranchant membre à membre (2) de (1), on obtient :

$$N(AlAs)-N(AlOx))xD(AlAs)=\lambda \qquad (2a)$$

On en déduit l'épaisseur de AlAs à transformer en oxyde AlOx .

$$D(AlAs)=\frac{\lambda}{N(AlAs)-N(AlOx)} \qquad (3)$$

En portant la valeur de D(AlAs) donnée par (3) dans (1), on obtient:

$$\frac{N(AlAs)}{N(AlAs)-N(AlOx)}x\lambda + N(GaAs)xD(GaAs) = kx\lambda \qquad (4)$$

On en déduit l'épaisseur de GaAs à utiliser pour le reste de la cavité :

$$D(GaAs)=\frac{1}{N(GaAs)}x(k-\frac{N(AlAs)}{N(AlAs)-N(AlOx)})x\lambda \qquad (5)$$

avec la condition importante :

$$k>\frac{N(AlAs)}{N(AlAs)-N(AlOx)} \quad et\ k\ entier\ naturel \qquad (6)$$

Le processus d'oxydation peut provoquer une très légère variation de l'épaisseur de la couche de AlAs. Dans ce cas, on peut introduire un coefficient correctif C dans l'équation (2) en remplaçant D(AlAs) par CxD (*AlAs*).

L'homme du métier transposerait aisément l'inégalité et les équations précédentes au cas où l'on utiliserait d'autres semiconducteurs et d'autres oxydes, en particulier au cas où la cavité 12 et la couche 22 seraient respectivement en $Ga_{1-x}Al_xAs$ et en $Ga_{1-y}Al_yAs$, avec y supérieur à x, de préférence supérieur à 10x (et $x \geq 0, y \leq 1$).

Illustrons ce qui précède par un exemple.

Les valeurs numériques des indices optiques que l'on utilise dans cet exemple sont des valeurs approchées. Il est bien entendu que l'on peut calculer des valeurs plus précises pour le système GaAlAs. En particulier, les références [5] et [6] fournissent des modèles numériques très précis.

Dans cet exemple, les valeurs moyennes des indices optiques à 850 nm sont les suivantes : N(AlAs)=2,9 N(GaAs)=3,5 N(AlOx)=1,6

Avec ces valeurs, les équations (1) à (5) et l'inégalité (6) conduisent à *k*>2,23 avec k entier, c'est-à-dire à k≥3.

On est donc obligé de réaliser une cavité 3xλ, au minimum pour cet ensemble d'indices optiques. Dans ce cas, l'équation (3) permet de calculer l'épaisseur de AlAs à utiliser (653,8nm) et l'une des deux équations (1) et (2) donne l'épaisseur de GaAs (186,8nm) qui est nécessaire pour achever la cavité.

Le tableau I suivant résume les valeurs numériques pour des cavités 3xλ, 4xλ et 5xλ

Tableau I

|  | GaAs | AlAs |
|---|---|---|
| 3xλ | 186,8nm | 653,8nm |
| 4xλ | 429,7nm | 653,8nm |
| 5xλ | 672,5nm | 653,8nm |

On peut répartir l'épaisseur de AlAs en plusieurs couches et disposer ces couches d'un seul côté des puits quantiques ou de part et d'autre de ces puits.

La figure 5 illustre l'exemple que l'on vient de donner à propos d'une diode conforme à l'invention, fonctionnant à la même longueur d'onde λ pour l'émission de lumière E et la détection de lumière D. Sur les figures 4 et 5, des éléments identiques ont les mêmes références.

Par rapport à la cavité résonante 12 du VCSEL de la figure 4, la cavité résonante 12 du VCSEL de la figure 5 contient deux couches supplémentaires 26 et 28 qui sont identiques à la couche 22 et parallèles à cette dernière (et donc aux miroirs 8 et 16). Ces couches supplémentaires ont été insérées lors de l'épitaxie conduisant à l'empilement que l'on voit sur la figure 5.

Par le processus d'oxydation décrit plus haut, on a oxydé partiellement les trois couches 24, 26 et 28 pour obtenir trois anneaux parallèles et électriquement isolants 24, 20 et 32 en AlOx. Ces anneaux ont le même diamètre interne et le même diamètre externe et ont un axe commun X qui constitue l'axe du VCSEL.

Comme on l'a vu plus haut, les anneaux pourraient être répartis de part et d'autre de la couche de puits quantiques 14 constituant le milieu à gain.

On pourrait aussi avoir plusieurs couches de milieu à gain et répartir comme on le souhaite les anneaux isolants de part et d'autre de ces couches de milieu à gain.

On a donc une cavité en deux parties qui sont définies par les anneaux 24, 30 et 32, à savoir une partie centrale cylindrique P1, dont l'axe est l'axe X et qui traverse les anneaux et forme localement une cavité kxλ, et une partie tubulaire P2 qui contient les anneaux, entoure la partie P1 et forme localement une cavité (k-1)xλ.

Il convient de noter que l'on peut oxyder des couches de AlAs jusqu'à une épaisseur de 250 nm (voir le document [7]). Par contre, dans un laser réel, il vaut mieux utiliser des épaisseurs plus faibles (voir le document [8]) pour éviter des problèmes dus au changement d'épaisseur de cette couche de AlAs.

On donne ci-après des exemples d'application de l'invention.

La figure 6 montre schématiquement un exemple de télémètre à trois dimensions, comprenant une matrice 34 de VCSEL émetteurs-récepteurs 36 conformes à l'invention. Un objet 38, par exemple un cube, reçoit une impulsion lumineuse 40 envoyée par le premier des VCSELs de la matrice, cette dernière étant pourvue de moyens électroniques de commande et de traitement 42. Une optique non représentée (par exemple une lentille ou un groupe de lentilles) peut également être placée entre la matrice et le cube.

L'impulsion est réfléchie par les différents points de l'objet et détectée par les autres VCSELs de la matrice qui sont alors utilisés en tant que détecteurs. Les moyens électroniques 42 calculent les décalages temporels entre les différentes impulsions réfléchies et détectées 44. Ensuite, le deuxième VCSEL de la matrice émet une impulsion et les autres VCSELs détectent l'impulsion réfléchie etc....

On utilise donc un balayage dans lequel chaque VCSEL est utilisé en tant qu'émetteur et récepteur. On arrive à reconstituer la forme de l'objet avec un tel télémètre.

L'invention s'applique aussi à la formation de liaisons optiques bidirectionnelles. Ceci est schématiquement illustré par la figure 7 où l'on voit deux VCSELs émetteurs-récepteurs 46 et 48 conformes à l'invention.

Ces VCSELs sont reliés par une fibre optique 50 et pourvus de moyens électroniques de commande 52 qui s'occupent de la gestion des communications entre VCSELs. Ces derniers basculent à tour de rôle du mode émetteur au mode récepteur. En détectant la fin d'un message marqué par une séquence bien définie, les moyens électroniques 52 utilisent un mode de fonctionnement ou l'autre.

A titre d'exemple, une séquence peut être la suivante : envoi d'un signal par le composant 46, réception par le composant 48, réponse par le composant 48 qui passe en mode émission, réception par le composant 46 qui passe en mode réception.

L'invention n'est pas limitée aux VCSELs. Elle s'applique aussi aux RCLEDs. A titre d'exemple, une RCLED

EP 1 501 161 B1

conforme à l'invention a la structure que l'on voit sur la figure 5 si ce n'est que la réflectivité des miroirs est plus faible.

On peut par exemple former une liaison bidirectionnelle du genre de celle de la figure 7 en reliant deux RCLEDs par une fibre optique.

Les documents cités dans la présente description sont les suivants :

[1] H. Kosaka, I. Ogura, M. Sugimoto, H. Saito, T. Numai et K. Kasahara, "Pixels consisting of double vertical-cavity detector and single vertical-cavity laser sections for 2-D bidirectional optical interconnections", Jpn. J. Appl. Phys., vol. 32, 1993, pp. 600-603

[2] T. Knodl, H. K. H. Choy, J. L. Pan, R. King, R. Jäger, G. Lullo, J. F. Ahadian, R. J. Ram, C. G. Fonstad, Jr., et K. J. Ebeling, "RCE Photodetectors based on VCSEL Structures", IEEE PHOTONICS TECHNOLOGY LETTERS, vol. 11, n° 10, 1999, pp. 1289-1291

[3] K. D. Choquette, K. L. Lear, R. P. Schneider, Jr. et K. M. Geib, "Cavity characteristics of selectively oxidized vertical-cavity lasers", Appl. Phys. lett. 66 (25), 1995, pp. 3413-3415

[4] K. L. Lear, K. D. Choquette, R. P. Schneider, Jr. et S. P. Kilcoyne, "Modal analysis of a small surface emitting laser with a selectively oxidized waveguide", Appl. Phys. Lett. 66 (20), 1995, pp. 2616-2618

[5] F. L. Terry, Jr., "A modified harmonic oscillator approximation scheme for the dielectric constants of $Al_xGa_{1-x}As$", J. Appl. Phys., 70 (1) , 1991, pp. 409-417

[6] M. A. Afromowitz, "Refractive index of $Ga_{1-x}Al_xAs$", Solid State Com., vol. 15, 1974, pp. 59-63

[7] M. Osinski, T. Svimonishvili, G. A. Smolyakov, V. A. Smagley, P. Mackowiak, et W. Nakwaski, "Temperature and Thickness Dependence of Steam Oxidation of AlAs in Cylindrical Mesa Structures", IEEE PHOTONICS TECHNOLOGY LETTERS, vol. 13, n° 7, 2001, pp. 687-689

[8] B. Weigl, "High-Efficiency Selectively-Oxidized MBE-Grown Vertical-Cavity Surface-Emitting Laser", Annual report 1995, Dept. 0f Optoelectronics, University of Ulm, pp. 102-105.

## Revendications

**1.** Diode à cavité résonante, apte à émettre et à détecter une lumière de longueur d'onde λ, cette diode comprenant :

- des premier et deuxième miroirs (8, 16),
- une cavité résonante (12) délimitée par ces premier et deuxième miroirs,
- un milieu actif (14) contenu dans cette cavité et apte à émettre et à détecter la lumière,
- un premier anneau électriquement isolant (24) qui est parallèle aux premier et deuxième miroirs et placé dans la cavité d'un côté du milieu actif, ce premier anneau définissant deux parties dans la cavité, à savoir une première partie cylindrique (P1) qui traverse le premier anneau et une deuxième partie (P2) qui contient ce premier anneau,

cette diode étant **caractérisée en ce qu'**elle comprend en outre au moins un deuxième anneau électriquement isolant (30, 32) qui est parallèle aux premier et deuxième miroirs et placé dans la cavité d'un côté du milieu actif, ce deuxième anneau étant contenu dans la deuxième partie (P2) de la cavité et ayant le même diamètre intérieur et le même diamètre extérieur que le premier anneau, l'épaisseur totale des premier et deuxième anneaux étant prévue pour que la cavité résonante ait une longueur optique kxλ dans la première partie (P1) et une longueur optique (k-1) x λ dans la deuxième partie (P2), k étant un nombre entier au moins égal à 2.

**2.** Diode selon la revendication 1, dans laquelle les premier et deuxième anneaux (24, 30, 32) sont formés par oxydation partielle de couches semiconductrices (22, 26, 28) qui sont parallèles aux premier et deuxième miroirs et comprises dans la cavité, l'oxydation ayant lieu dans toute la portion de ces couches qui est située dans la deuxième partie (P2) de la cavité et k étant supérieur à n1/(n1-n2), où n1 et n2 désignent respectivement l'indice optique du matériau constitutif des couches semiconductrices et l'indice optique de ce matériau après oxydation.

**3.** Diode selon la revendication 2, dans laquelle la cavité (12) est faite d'un matériau semiconducteur ternaire $A_{1-x}B_xC$,

apte à être oxydé, avec 0≤x≤1.

**4.** Diode selon la revendication 3, dans laquelle les éléments chimiques A, B et C sont respectivement Ga, Al et As.

**5.** Diode selon l'une quelconque des revendications 1 à 4, dans laquelle le milieu actif est un milieu à gain (14) et la diode est un laser à émission par la surface, à cavité verticale.

**6.** Diode selon l'une quelconque des revendications 1 à 4, dans laquelle le milieu actif (54) est apte à émettre et à détecter la lumière et la diode est une diode électroluminescente à cavité résonante.

**7.** Télémètre comprenant la diode selon la revendication 5.

**8.** Composant émetteur-récepteur de lumière, comprenant une matrice (34) de diodes selon l'une quelconque des revendications 1 à 6.

**9.** Télémètre à trois dimensions, comprenant une matrice (34) de diodes selon la revendication 5.

**10.** Liaison optique bidirectionnelle comprenant :

- deux diodes émettrices-réceptrices (46, 48) selon l'une quelconque des revendications 1 à 6 et
- un guide d'onde optique (50) qui relie ces deux diodes.

**Claims**

**1.** Resonant cavity diode capable of emitting and detecting light with a wavelength $\lambda$, this diode comprising:

- first and second mirrors (8, 16),
- a resonant cavity (12) delimited by these first and second mirrors,
- an active medium (14) contained in this cavity and capable of emitting and detecting light,
- a first electrically insulating ring (24) parallel to the first and second mirrors and placed in the cavity on one side of the active medium, this first ring defining two parts in the cavity, namely a first cylindrical part (P1) passing through the first ring and a second part (P2) that contains this first ring,

this diode being **characterized in that** it further comprises at least one second electrically insulating ring (30, 32) parallel to the first and second mirrors and placed in the cavity on one side of the active medium, this second ring being contained in the second part (P2) of the cavity and having the same inside diameter and the same outside diameter as the first ring, the total thickness of the first and second rings being provided such that the optical length of the resonant cavity is $k \times \lambda$ in the first part (P1) and $(k-1) \times \lambda$ in the second part (P2), where k is an integer number equal to at least 2.

**2.** Diode according to claim 1, in which the first and second rings (24, 30, 32) are formed by partial oxidation of semiconducting layers (22, 26, 28) parallel to the first and second mirrors and included within the cavity, oxidation taking place throughout the portion of these layers located in the second part (P2) of the cavity and where k is greater than $n1/(n1-n2)$, where $n1$ and $n2$ denote the optical index of the material from which the semiconducting layers are made and the optical index of this material after oxidation, respectively.

**3.** Diode according to claim 2, in which the cavity (12) is made of a ternary semiconducting material $A_{1-x}B_xC$, capable of being oxidized, where 0≤x≤1.

**4.** Diode according to claim 3, in which the chemical elements A, B and C are Ga, Al and As respectively.

**5.** Diode according to any one of claims 1. to 4, in which the active medium is a gain medium (14) and the diode is a vertical cavity surface emitting laser.

**6.** Diode according to any one of claims 1 to 4, in which the active medium (54) is capable of emitting and detecting light and the diode is a resonant cavity light emitting diode.

**7.** Telemeter comprising the diode according to claim 5.

**8.** Light emitter-receiving component, comprising a matrix (34) of diodes according to any one of claims 1 to 6.

**9.** Three dimensional telemeter, comprising a matrix (34) of diodes according to claim 5.

**10.** Bi-directional optical connection comprising:

- two emitting-receiving diodes (46, 48) according to any one of claims 1 to 6 and
- an optical waveguide (50) connecting these two diodes.


**Patentansprüche**

**1.** Resonanzraum-Diode, fähig ein Licht der Wellenlänge $\lambda$ zu emittieren und zu detektieren, wobei diese Diode umfasst:

- einen ersten und zweiten Spiegel (8, 16),
- einen durch den ersten und zweiten Spiegel begrenzten Resonanzraum (12),
- ein in diesem Resonanzraum enthaltenes und zur Emission und Detektion von Licht geeignetes aktives Medium (14),
- einen ersten elektrisch isolierenden Ring (24), der parallel ist zu dem ersten und zweiten Spiegel und in dem Resonanzraum auf einer Seite des aktiven Mediums angeordnet ist,

wobei dieser erste Ring in dem Resonanzraum zwei Teile definiert, nämlich einen ersten zylindrischen Teil (P1), der den ersten Ring durchquert, und einen zweiten Teil (P2), der diesen ersten Ring enthält;
dabei ist diese Diode **dadurch gekennzeichnet, dass** sie außerdem wenigstens einen zweiten elektrisch isolierenden Ring (30, 32) umfasst, der parallel ist zu dem ersten und zweiten Spiegel und in dem Resonanzraum auf einer Seite des aktiven Mediums angeordnet ist, wobei dieser zweite Ring in dem zweiten Teil (P2) des Resonanzraums enthalten ist und den gleichen Innendurchmesser und den gleichen Außendurchmesser wie der erste Ring hat, wobei die Gesamtdicke der ersten und zweiten Ringe so vorgesehen ist, dass die optische Länge des Resonanzraums in dem ersten Teil (P1) $k \times \lambda$ beträgt und in dem zweiten Teil (P2) $(k-1) \times \lambda$, wobei k eine ganze Zahl $\geq 2$ ist.

**2.** Diode nach Anspruch 1, bei welcher die ersten und zweiten Ringe (24, 30, 32) durch partielle Oxidation von Halbleiterschichten (22, 26, 28) gebildet werden, die zu dem ersten und zweiten Spiegel parallel und in dem Resonanzraum enthalten sind, wobei die Oxidation in dem gesamten im zweiten Teil (P2) des Resonanzraums befindlichen Teilstück dieser Schichten stattfindet und k größer ist als n1/(n1-n2), wo n1 und n2 jeweils die Brechzahl des die Halbleiterschichten bildenden Materials und die Brechzahl dieses Materials nach der Oxidation bezeichnen.

**3.** Diode nach Anspruch 2, bei welcher der Resonanzraum (12) aus einem oxidationsfähigen ternären Halbleitermaterial $A_{1-x}B_xC$ mit $0 \leq x \leq 1$ gemacht ist.

**4.** Diode nach Anspruch 3, bei welcher die chemischen Elemente A, B und C jeweils Ga, Al und As sind.

**5.** Diode nach einem der Ansprüche 1 bis 4, bei der das aktive Medium ein Verstärkungsmedium (14) ist und die Diode ein Oberflächenemissions-Laser mit vertikalem Resonanzraum ist.

**6.** Diode nach einem der Ansprüche 1 bis 4, bei der das aktive Medium (54) fähig ist, Licht zu emittieren und zu detektieren, und die Diode eine Elektrolumineszenzdiode mit Resonanzraum ist.

**7.** Telemeter, die Diode nach Anspruch 5 umfassend.

**8.** Bauteil zum Senden und Empfangen von Licht, eine Diodenmatrix (34) nach einem der Ansprüche 1 bis 6 umfassend.

**9.** Dreidimensionales Telemeter, eine Diodenmatrix nach Anspruch 5 umfassend.

**10.** Bidirektionale optische Verbindung, umfassend:

- zwei Sende-Empfangsdioden (46, 48) nach einem der Ansprüche 1 bis 6, und

- einen Lichtwellenleiter (50), der diese beiden Dioden verbindet.

FIG. 1

FIG. 2

FIG. 3

FIG. 4

FIG. 5

## FIG. 6

## FIG. 7